# EUROPÄISCHE PATENTANMELDUNG

(11) **EP 3 208 843 A1**
(43) Veröffentlichungstag der Anmeldung: **23.08.2017**
(21) Anmeldenummer: 16000389.3
(22) Anmeldetag: 17.02.2016
(51) Int. Cl.: H01L 23/40, F16B 2/24

(54) **HALTEKLAMMER**

(71) Anmelder: ELinter AG, 6330 Cham (CH)
(72) Erfinder: Doswald, Jörg A., CH-6335 Weggis (CH)
(74) Vertreter: Ebert, Jutta

(57) **Zusammenfassung**

Die Erfindung betrifft eine Halteklammer für die Montage quaderförmiger Klein-Bauteile, insbesondere quaderförmiger Halbleiter-Bauelemente, auf einer ebenen Trägerfläche mit mindestens einer gebogenen Niederhalte-Blattfeder, deren eines Ende mit der Trägerfläche verbindbar ist und deren anderes Ende zur federnden Auflage auf einem auf der Trägerfläche platzierten, quaderförmigen Bauelement gebracht wird. Nach der Erfindung besteht die Niederhaltefeder (2) der Halteklammer (1) aus einer Blattfeder (3) aus Federstahl, deren beide Enden (5) ausgehend von einem Mittelsteg (6) spiegelbildlich zuerst nach oben, dann nach unten und dann einwärts zu einer offenen Öse (6) oder Rundung (27) gebogen sind. Um die Halteklammer (1) spannungsfest zu machen, ist die Federstahl-Blattfeder (3) mit einer Kunststoffschicht (4) überzogen. Mit nur einer so geformten Niederhaltefeder (2) können zugleich zwei Halbleiter-Bauelemente (13) auf der Trägerfläche (12) montiert und gehalten werden. Werden mehrere solche Niederhaltefedern (2) mit einem erfindungsgemäßen Klammerträger (16) zur Halteklammer verbunden, können entsprechend mehr Halbleiter-Bauelemente (13) zugleich montiert werden; die Halteklammer kann mit nur einer Befestigungsschraube (10) auf der Trägerfläche montiert werden (Fig. 12).

## Beschreibung

Die Erfindung bezieht sich auf eine Halteklammer für die Montage quaderförmiger Klein-Bauteile auf einer ebenen Trägerfläche mit mindestens einer gebogenen Niederhalte-Blattfeder, deren eines Ende mit der Trägerfläche verbindbar ist und deren anderes Ende zur federnden Auflage auf einem auf der Trägerfläche platzierten, quaderförmigen Bauteil bringbar ist.

Im Bereich der Elektronik sind Halbleiter-Bauelemente bekannt, bei denen die eigentlichen Halbleiter in ein quaderförmiges Gehäuse aus Kunststoff eingegossen sind und die zur Verwendung in einem elektronischen Schaltkreis in bestimmter Anordnung auf eine Trägerfläche montiert werden. Für die Montage sind Halteklammern bekannt, die aus einer oder mehreren zungenförmigen Blattfedern aus Federstahl bestehen, die zweifach, erst von der Trägerfläche weg, dann auf die Trägerfläche zu, gebogen sind und deren eines Ende fest, bevorzugt mit Hilfe einer Schraube, mit der Trägerfläche verbindbar ist und deren freies, von der Trägerfläche weg gebogenes Ende bei der Montage auf dem Halbleiter-Bauelement zur Auflage kommt und dabei den erforderlichen Anpressdruck ausüben soll, um das Halbleiter-Bauelement wirksam gegen die Trägerfläche zu pressen. Es ist eine Mehrfach-Halteklammer bekannt, bei der die einen Enden einer Reihe solcher Blattfedern mit einem gemeinsamen Steg verbunden sind, über den die feste Verbindung mit der Trägerfläche mittels Schrauben hergestellt werden kann. Entsprechend der Anzahl der Blattfedern lassen sich mehrere Halbleiter-Bauelemente an diese Mehrfach-Halteklammer anschließen. Um sicher zu stellen, dass die einzelnen Blattfedern und die Halteklammer als Ganzes sicher auf der Trägerfläche aufliegen können und den erforderliche Anpressdruck ausüben können, ist dabei für jede einzelne der Blattfedern eine Schraubverbindung an dem sie verbindenden Steg und an der Trägerfläche vorgesehen. Dies macht die Montage der Halteklammer umständlich und zeitaufwendig. Diese Mehrfach-Halteklammer ist auch nur für die Montage mehrerer Halbleiter-Bauelemente gleicher Bauhöhe geeignet; Bauelemente unterschiedlicher Bauhöhe, die neben einander eingesetzt werden, müssen immer umständlich einzeln montiert werden, da sonst ein ausreichender Anpressdruck auf die Bauelemente nicht gewährleistet werden kann.

Es handelt sich bei diesen Halbleiter-Bauelementen vorzugsweise um Halbleiter höherer Leistungsklasse. Die Blattfedern der bekannten Halteklammern sind nicht isoliert. Um einen Spannungs-Durchschlag zu vermeiden, wird an den Schraubverbindungen eine Isolierung vorgesehen; dabei sollte eine Spannungsfestigkeit von mindestens 4kV oder mehr erreicht werden. Außerdem müssen die Halbleiter höherer Leistungsklasse gekühlt werden. Dazu werden z.B. wärmeleitende Isoliermatten, z.B aus Silikon, als Zwischenlage zwischen den Halbleiter-Bauelementen und der Trägerfläche, die Teil eines Kühlkörpers sein kann, eingesetzt. Auch ist es bekannt, an einem quaderförmigen Halbleiter-Bauelement eine Kühlfahne vorzusehen, die in Kontakt gebracht wird mit einem separaten Kühlkörper. Der Montagevorgang wird durch diese Maßnahmen weiter verkompliziert.

Es wurde bereits vorgeschlagen, die Befestigung der zungenförmigen Blattfedern anstatt mit Schrauben mit einem Federclip aus Federstahl vorzunehmen, damit lässt sich aber lediglich ein Anpressdruck von 2kp bis 3kp am Halbleiter-Bauelement erreichen. Dies wird als nicht ausreichend angesehen, besonders für den Fall, dass ein Gerät, für das diese Halbleiter-Bauelemente eingesetzt werden, auch Vibrationen oder Stößen ausgesetzt sein kann. Außerdem hat sich gezeigt, dass die zungenförmigen Blattfedern der bekannten Halteklammern bruchgefährdet sind.

Aufgabe der vorliegenden Erfindung ist es, eine Halteklammer für die Montage von quaderförmigen Bauelementen, und bevorzugt von quaderförmigen Halbleiter-Bauelementen auf einer ebenen Trägerfläche zu schaffen, die mit wenigen Handgriffen leicht, schnell und sicher auf der Trägerfläche montierbar ist. Dabei muss die für Halbleiter höherer Leistungsklasse notwendige Spannungsfestigkeit oder Durchschlagsfestigkeit von mindestens 4kV besser von 6kV gewährleistet sein, und die Halteklammer soll einen höheren Anpressdruck auf das montierte Halbleiter-Bauelement ausüben können als bekannte Halteklammern. Eine ausreichende Kühlung der Halbleiter-Bauelemente muss gewährleistet sein. Die Anordnung aus Halteklammer und Halbleiter-Bauelemente soll unempfindlich gegenüber Temperaturschwankungen, Vibrationen und Stößen sein.

Dies wird erfindungsgemäß mit einer Halteklammer gemäß Anspruch 1 erreicht.

Die Niederhaltefeder der erfindungsgemäßen Halteklammer besteht in ihrer Basisausführung aus einer Blattfeder aus Federstahl, deren beide Enden ausgehend von einem Mittelsteg spiegelbildlich zuerst nach oben, dann nach unten und dann einwärts zu einer offenen Öse oder Rundung gebogen sind. Mit einer so geformten Niederhaltefeder aus Federstahl lassen sich eine hohe Federspannung und ein hoher Anpressdruck auf die zu montierenden quaderförmigen Bauelemente erreichen. Ein Anpressdruck von nachweislich 7kp wurde erreicht.

Die Halteklammer soll bevorzugt auch bei Halbleiter-Bauelementen höherer Leistungsklasse eingesetzt werden können. Wenn die Niederhaltefeder erfindungsgemäß mit einer elektrisch isolierenden Kunststoffschicht überzogen ist, kann nicht nur die bei Prüfungen geforderte Spannungsfestigkeit von 4kV, sondern sogar eine höherer Wert erreicht werden; es wurde eine Spannungsfestigkeit von 6kV nachgewiesen. Eine Isoliermatte wird nicht benötigt.

Nach einer Ausführungsform der Erfindung ist die Niederhaltefeder an ihrer Unterseite mit einem elektrisch isolierenden Sockel, bevorzugt aus Kunststoff, verbunden, der zwischen ihren beiden abgebogenen Enden hindurchragt. Mit einer Befestigungsschraube, die durch den Mittelsteg und den Sockel hindurchragt kann die Halteklammer mit der Trägerfläche eines Unterbaus, auf dem die Halbleiter-Bauelemente montiert werden sollen, verbunden werden. Aufgrund der erfindungsgemäß geformten Niederhaltefeder lassen sich mit einer Halteklammer dieser Ausführungsform zugleich zwei Halbleiter-Bauelemente auf der Trägerfläche sicher montieren.

Der Mittelsteg kann nach oben von der Fläche der Niederhaltefeder abragen und zum Schutz durch eine metallene Kappe abgedeckt sein, die ebenfalls von der Befestigungsschraube durchstoßen wird.

Es ist vorteilhaft, wenn die Unterseite der einwärts zu Ösen gebogenen Enden der Niederhaltefeder zusätzlich zur isolierenden Kunststoffschicht mit einem Kunststoffpad belegt ist. Dieses Kunststoffpad erhöht einerseits weiter den Anpressdruck der Niederhaltefeder und erleichtert andererseits die Montage oder Platzierung der quaderförmigen Halbleiter-Bauelemente, indem diese auf dem jeweiligen Kunststoffpad gleiten können.

Nach einer vorteilhaften Ausführungsform der Erfindung sind mehr als eine erfindungsgemäße Niederhaltefeder mit einem Klammerträger verbunden, von dem ein Sockel abragt, der wiederum von einer Befestigungsschraube durchstoßen wird, mit der der Klammerträger samt Niederhaltefedern auf der Trägerfläche eines Unterbaus befestigt werden kann. Es lassen sich mit einer solchen Ausführungsform der Halteklammer mehrere Niederhaltefedern für mehrere Halbleiter-Bauelemente auch unterschiedlicher Größe und Dicke mit nur einer Befestigungsschraube auf der Trägerfläche befestigen. Die Montagearbeit wird so erheblich vereinfacht und zeitsparend.

Der Klammerträger weist bevorzugt einen U-förmigen, aus einem Boden und zwei Seitenwänden gebildeten Körper auf, der durch Stützwände innerhalb der U-Form gestützt ist. Außen von der Mitte des Bodens ragt der Sockel ab, und beidseitig des Sockels und im Abstand zum Sockel sind vom Boden abstehende Fortsätze ausgeformt, an denen jeweils eine erfindungsgemäße Niederhaltefeder befestigt ist. Der Klammerträger dient einerseits zur Befestigung der Halteklammer an der Trägerfläche und kann andererseits auch aus Kühlkörper wirken. Mit der U-Form wird eine dafür günstige große Abstrahlfläche erreicht

Jede der Niederhaltefedern kann vorteilhaft über ihren nach oben von ihrer Fläche abragenden Mittelsteg durch eine Schnappverbindung und/oder eine Schraubverbindung mit einem der Fortsätze des Klammerträgers verbunden sein.

Der Klammerträger kann aus einem Gussteil bestehen, und die einzige den Sockel durchstoßende Befestigungsschraube ist bevorzugt von einer isolierenden Kunststoffhülse eingefasst, um die erforderliche Spannungsfestigkeit zu erreichen und Kriechströme zu vermeiden oder zumindest zu minimieren.

Nach einer Ausführungsform der Erfindung ist am Klammerträger beidseitig seines Sockels und zu ihm beabstandet spiegelbildlich jeweils ein Fortsatz ausgebildet, und an den beiden Fortsätzen ist jeweils eine Niederhaltefeder befestigt. Man erreicht damit eine Vierfach-Halteklammer; mit ihr lassen sich zugleich vier verschiedene Halbleiter-Bauelemente auf einer Trägerfläche sicher montieren, und es wird dafür nur eine Befestigungsschraube benötigt.

Nach einer anderen Ausführungsform der Erfindung sind am Klammerträger auf einer Seite des Sockels zueinander beabstandet zwei Fortsätze ausgebildet und auf der anderen Seite des Sockels ist ein Fortsatz ausgebildet, und an jedem der Fortsätze ist eine Niederhaltefeder befestigt. Man erreicht damit eine Sechsfach-Halteklammer; mit ihr lassen sich zugleich sechs verschiedene Halbleiter-Bauelemente auf einer Trägerfläche sicher montieren, und dafür wird wiederum nur eine Befestigungsschraube gebraucht. Dabei können sich die Halbleiter-Bauelemente nach Größe und/oder Dicke auch unterscheiden, ohne dass besondere Anpassungen notwendig werden.

Nach einer weiteren Ausführungsform sind am Klammerträger beidseitig seines Sockels und zu ihm beabstandet spiegelbildlich jeweils zwei zueinander beabstandete Fortsätze ausgebildet, und an jedem der Fortsätze ist eine Niederhaltefeder befestigt. Man erhält so eine Achtfach-Halteklammer; mit ihr lassen sich zugleich acht verschiedene Halbleiter-Bauelemente auf einer Trägerfläche sicher montieren und halten, und es wird dafür ebenfalls nur eine Befestigungsschraube benötigt.

Nach einer anderen vorteilhaften Ausführungsform der Erfindung besteht die Halteklammer aus zwei Teilen, einem oberen Teil und einem unteren Teil. Dabei erstrecken sich am oberen Teil ausgehend von einem Mittelsteg spiegelbildlich nach beiden Seiten eine Reihe von Niederhaltefedern aus Federstahl, deren freies Ende ausgehend von einem Mittelsteg jeweils zuerst nach oben, dann nach unten und dann einwärts zu einer Rundung gebogen ist. Am unteren Teil erstrecken sich ausgehend von einem Mittelsteg spiegelbildlich nach beiden Seiten eine Reihe von Blattfedern aus Kunststoff, deren freies Ende ausgehend vom Mittelsteg jeweils zuerst nach oben, dann nach unten und dann aufwärts zu einer Mulde gebogen ist. Dabei entsprechen sich das obere Teil und das untere Teil nach Größe und Maße derart, dass beim Einsetzen des oberen Teils in das untere Teil die Mittelstege beider Teile zur Deckung kommen und die Niederhaltefedern des oberen Teils mit ihrer Rundung zur Auflage kommen in den Mulden der Blattfedern des unteren Teils. Diese Halteklammer lässt sich für die Montage einer unterschiedlichen Anzahl von Halbleiter-Bauelementen variieren, indem die Anzahl sowohl der Niederhaltefedern am oberen Teil als auch der Kunststoff-Blattfedern am unteren Teil entsprechend angepasst wird. Das untere Teil dieser Halteklammer besteht aus Kunststoff, damit die geforderte Spannungsfestigkeit gewährleistet werden kann.

Vorzugsweise können an der Unterseite der Mulden der Kunststoff-Blattfedern Aufstandsflächen ausgebildet sein, um eine sichere Haftung auf der Trägerfläche zu gewährleisten.

Zur Befestigung dieser Halteklammer auf der Trägerfläche können die Mittelstege eine Reihe von Schraublöchern aufweisen, die beim Einsetzen des oberen Teils in das untere Teil zur Deckung kommen.

Vorteilhaft können das obere Teil und das untere Teil der Halteklammer durch eine Schnappverbindung an den Schmalseiten der Mittelstege miteinander verbunden sein.

Wenn die zur Deckung gebrachten Mittelstege von einer Metallschiene abgedeckt sind, die Schraublöcher aufweist, die mit den Schraublöchern der Mittelstege zur Deckung kommen, erhält die Halteklammer zusätzliche Stabilität.

Die Erfindung wird im Folgenden anhand der anhängenden Zeichnungen und am Beispiel verschiedener Ausführungsformen genauer beschrieben; es zeigen:
- Fig. 1: in Perspektive eine Draufsicht auf eine Ausführungsform der erfindungsgemäßen Halteklammer als Zweifach-Halteklammer,
- Fig. 2: in Perspektive einen Blick auf die Unterseite der Halteklammer nach Fig. 1,
- Fig. 3: die Vorderansicht oder Rückansicht der Halteklammer nach Fig. 1,
- Fig. 4: eine Seitenansicht der Halteklammer nach Fig. 1,
- Fig. 5: die Draufsicht auf die Halteklammer nach Fig. 1,
- Fig. 6: in Perspektive eine Draufsicht auf die Halteklammer nach Fig. 1 mit Einbauumgebung,
- Fig. 7: in Perspektive eine Draufsicht auf eine zweite Ausführungsform der erfindungsgemäßen Halteklammer als Vierfach- Halteklammer,
- Fig. 8: in Perspektive einen Blick auf die Unterseite der Halteklammer nach Fig. 7,
- Fig. 9: die Vorderansicht oder Rückansicht der Halteklammer nach Fig. 7,
- Fig. 10: eine Seitenansicht der Halteklammer nach Fig. 7,
- Fig. 11: die Draufsicht auf die Halteklammer nach Fig. 7,
- Fig. 12: in Perspektive eine Draufsicht auf die Halteklammer nach Fig. 7 mit Einbauumgebung,
- Fig. 13: in Perspektive eine Draufsicht auf eine dritte Ausführungsform der erfindungsgemäßen Halteklammer als Sechsfach-Halteklammer,
- Fig. 14: in Perspektive eine Draufsicht auf eine vierte Ausführungsform der erfindungsgemäßen Halteklammer als Achtfach-Halteklammer,
- Fig. 15: in Perspektive einen Blick auf die Unterseite der Halteklammer nach Fig. 14,
- Fig. 16: die Vorderansicht oder Rückansicht der Halteklammer nach Fig. 14,
- Fig. 17: eine Seitenansicht der Halteklammer nach Fig. 14,
- Fig. 18: die Draufsicht auf die Halteklammer nach Fig. 14,
- Fig. 19: in Perspektive eine Draufsicht auf die Halteklammer nach Fig. 14 mit Einbauumgebung,
- Fig. 20: in Perspektive eine Draufsicht auf eine weitere Ausführungsform der erfindungsgemäßen Halteklammer als Achtfach-Halteklammer,
- Fig. 21: in Perspektive einen Blick auf die Unterseite der Halteklammer nach Fig. 20,
- Fig. 22: die Vorderansicht der Halteklammer nach Fig. 20,
- Fig. 23: die Rückansicht der Halteklammer nach Fig. 20,
- Fig. 24: eine Seitenansicht der Halteklammer nach Fig. 20,
- Fig. 25: die Draufsicht auf die Halteklammer nach Fig. 20,
- Fig. 26: in Perspektive eine Draufsicht auf die Halteklammer nach Fig. 20 mit Einbauumgebung,
- Fig. 27: in Perspektive eine Draufsicht auf eine Abwandlung der Ausführungsform nach Fig. 20 als Vierfach-Halteklammer und
- Fig. 28: in Perspektive eine Draufsicht auf eine Abwandlung der Ausführungsform nach Fig. 20 als Sechsfach-Halteklemmer.

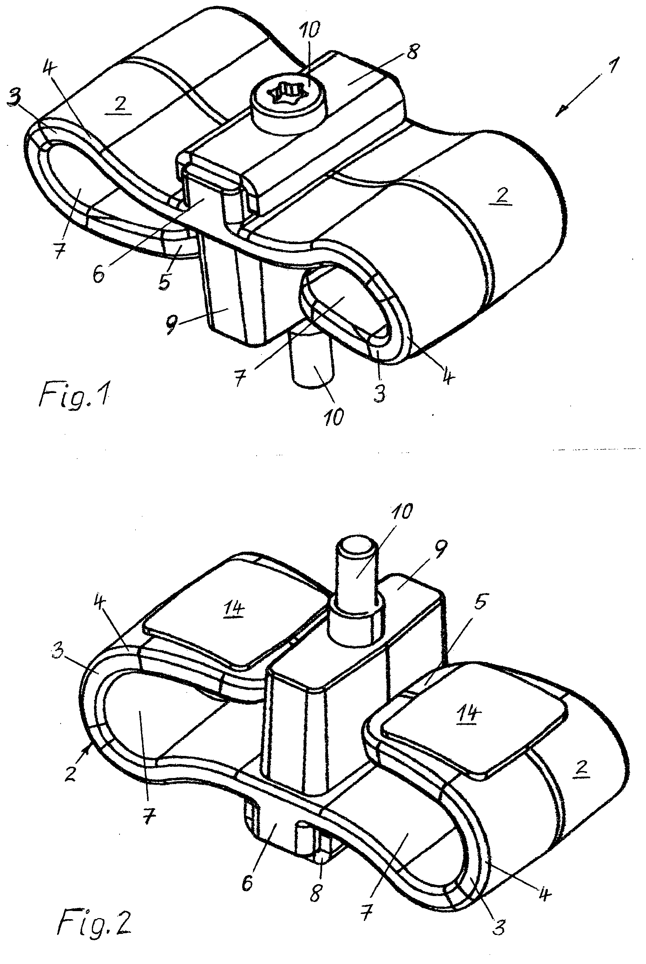

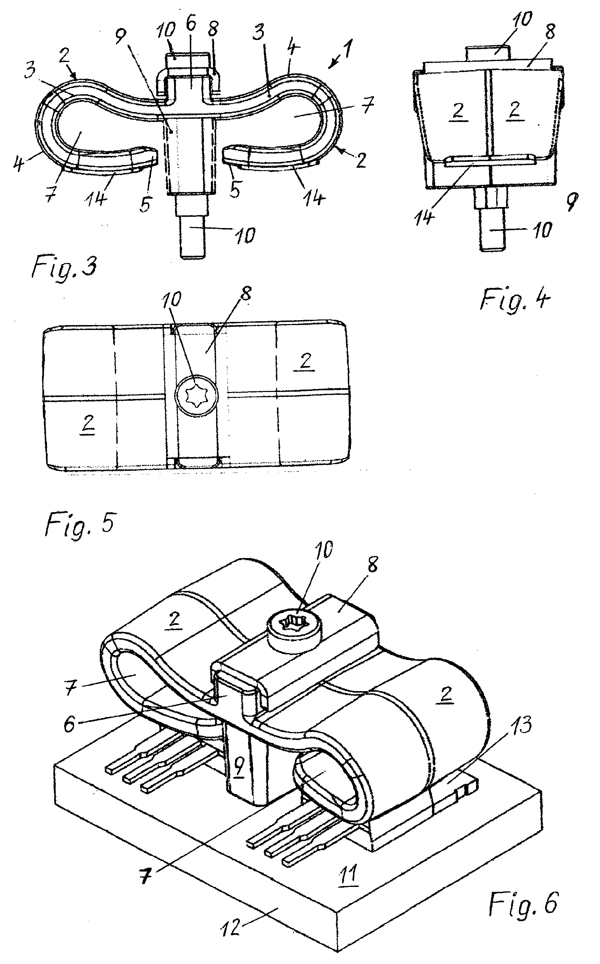

Fig. 1 bis Fig. 6 zeigen eine Basis-Ausführungsform der erfindungsgemäßen Halteklammer1; sie besteht aus einer Niederhaltefeder 2, die eine Blattfeder 3, vorzugsweise aus Federstahl, umfasst, welche mit einer elektrisch isolierenden Kunststoffschicht 4 überzogen, vorzugsweise umspritzt ist. Die beiden Enden 5 der Niederhaltefeder 2 sind ausgehend von einem Mittelsteg 6, spiegelbildlich zuerst nach oben und dann nach unten und einwärts zu jeweils einer offenen Öse 7 oder Rundung gebogen. Der Mittelsteg 6 ragt nach oben von der Fläche der Niederhaltefeder 2 ab und kann zum Schutz durch eine vorzugsweise metallene Kappe 8 abgedeckt sein. Die Niederhaltefeder 2 ist an ihrer Unterseite gegenüber dem Mittelsteg 6 fest mit einem elektrisch isolierenden Sockel 9, vorzugsweise aus Kunststoff, verbunden, der zwischen den beiden abgebogenen Enden 5 der Niederhaltefeder 2 hindurchragt. Eine Befestigungsschraube 10 ragt durch die Kappe 8, den Mittelsteg 6 und den Sockel 9 hindurch; mit ihr kann die Halteklammer 1 als Ganzes auf einer flachen Trägerfläche 11 eines Unterbaus 12 befestigt werden (siehe Fig. 6). Indem die aus Federstahl bestehende Blattfeder 3 der Niederhaltefeder 2 mit einer elektrisch isolierenden Kunststoffschicht 4 überzogen, vorzugsweise umspritzt ist, kann nicht nur die bei Prüfungen geforderte Spannungsfestigkeit von 4kV garantiert werden, sondern sogar ein höherer Wert erreicht werden; eine Spannungsfestigkeit von 6kV wurde nachgewiesen. Mit der geeigneten Wahl des Federstahls für die Blattfeder 3 lassen sich eine hohe Federspannung und ein gewünschter hoher Anpressdruck der Feder erreichen, die durch die erfindungsgemäße Form der Niederhaltefeder noch verstärkt wird. (siehe unten).

Wie in Fig. 6 dargestellt, soll die erfindungsgemäße Halteklammer 1 insbesondere bei der Montage von quaderförmigen, bedrahteten Halbleiter-Baulementen 13 auf einer flachen Trägerfläche 11, zum Einsatz kommen. Mit der oben beschriebenen Basis-Ausführungsform als Zweifach-Halteklammer können zwei Halbleiter-Bauelemente 13 auf der Trägerfläche 11 montiert werden, wobei nur eine Befestigungsschraube 10 an der Halteklammer 1 benötigt wird. Die Unterseite der zu Ösen 7 gebogenen Niederhaltefeder 2 kommt dabei zur Auflage auf jeweils einem Halbleiter-Bauelement 13, und die Niederhaltefeder 2 presst beide Halbleiter-Bauelemente 13 auf die Trägerfläche 11 eines Unterbaus 12, z.B. eines Kühlkörpers. Dabei wird mit der erfindungsgemäßen Halteklammer 1 ein garantierter Anpressdruck von 7kp erreicht, so dass auch Halbleiter-Bauelementen 13 unterschiedlicher Dicke zugleich mit derselben Halteklammer 1 sicher montiert werden können, ohne dass irgendwelche Anpassungen notwendig werden. Vorzugsweise ist die auf den Halbleiter-Bauelementen 13 zur Auflage kommende Unterseite der zu Ösen 7 gebogenen Niederhaltefeder 2 zusätzlich zur isolierenden Kunststoffschicht 4 jeweils mit einem Kunststoffpad 14 belegt (siehe Fig. 2). Dieses Kunststoffpad 14 erhöht einerseits weiter den Anpressdruck der Niederhaltefeder 2, andererseits erleichtert es die Montage oder die Platzierung der Halbleiter-Bauelemente13, indem diese auf dem jeweiligen Kunststoffpad 14 gleiten können.

Der Kunststoff für die elektrisch isolierende Kunststoffschicht 4 der Halteklammer 1 ist so gewählt, dass er bei dem erreichbaren Anpressdruck von 7 kp und auch bei höheren Temperaturen - es können Oberflächentemperaturen von bis zu 120° auftreten - stabil bleibt. Thermische Bewegung im Kunststoff wirkt einer Ermüdung des Materials entgegen und verringert die Bruchgefahr für die Niederhaltefeder 2. Temperaturspitzen werden geglättet. Die erfindungsgemäße Halteklammer 1 hat so eine lange Lebensdauer und kann viele Temperaturzyklen aushalten. Die Kunststoffschicht 4 und die Kunststoffpads 14 machen die Halteklammer 1 auch unempfindlich gegen Vibrieren oder Stöße von außen. Die Niederhaltefeder 2 der Halteklammer 1 weist eine hohe Federspannung und damit einen sehr geringen Federweg auf, was der gesamten Anordnung einschließlich der montierten Halbleiter-Bauelemente 13 Stabilität verleiht.

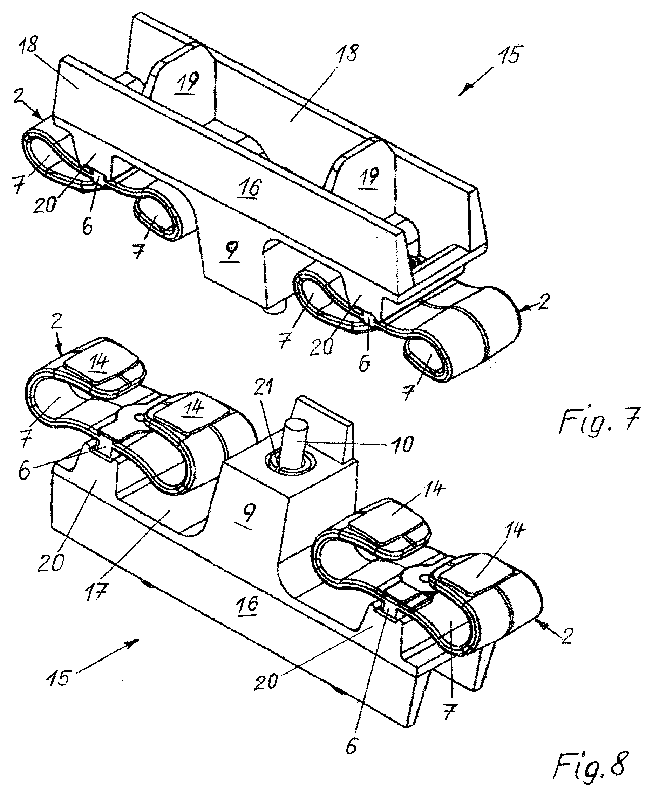

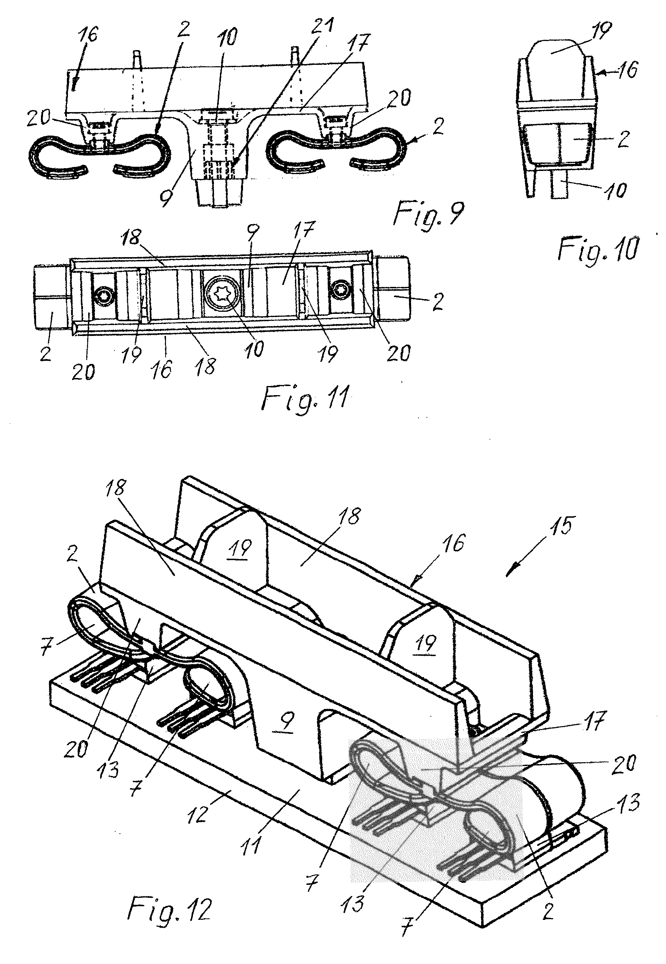

Fig. 7 bis Fig. 12 zeigen eine Ausführungsform der Erfindung als Vierfach-Halteklammer 15, d.h. mit nur einer solchen Halteklammer 15 und nur einer Befestigungsschraube 10 können bis zu vier Halbleiter-Bauelemente 13 auf einer Trägerfläche 11 montiert werden (siehe Fig. 12).

Ein länglicher Klammerträger 16 weist einen Boden 17 und zwei Seitenwände 18 auf, die gemeinsam eine U-Form bilden, diese wird durch Stützwände 19 gestützt, die innerhalb der U-Form die beiden Seitenwände 18 verbinden. Außen am Boden 17 des Klammerträgers 16 ist mittig ein Sockel 9 angeformt. Beidseitig und im Abstand zum Sockel 9 sind vom Boden 17 abstehend zwei Fortsätze 20 ausgebildet. An diesen Fortsätzen 20 können z.B. mittels Schnappverbindung und/oder Schraubverbindung Niederhaltefedern 2, wie sie oben beschrieben wurden, befestigt werden. Mit nur einer durch den Sockel 9 des Klammerträgers 16 hindurchgehenden Befestigungsschraube 10 (siehe Fig. 9) kann die Vierfach-Halteklammer 15 samt den daran befestigten Niederhaltefedern 2 auf der Trägerfläche 11 eines Unterbaus 12 befestigt werden, wie in Fig. 12 gezeigt. Mit dem erfindungsgemäßen Klammerträger 16 wird der erforderliche Anpressdruck der Niederhaltefedern 2 an den Halbleiter-Bauelementen 13 gewährleistet. Im Innern des Sockels 9 ist die Befestigungsschraube 10 von eine Kunststoffhülse 21 umgeben, die als Sicherung wirkt, um Kriechströme zu vermeiden oder zumindest zu minimieren.

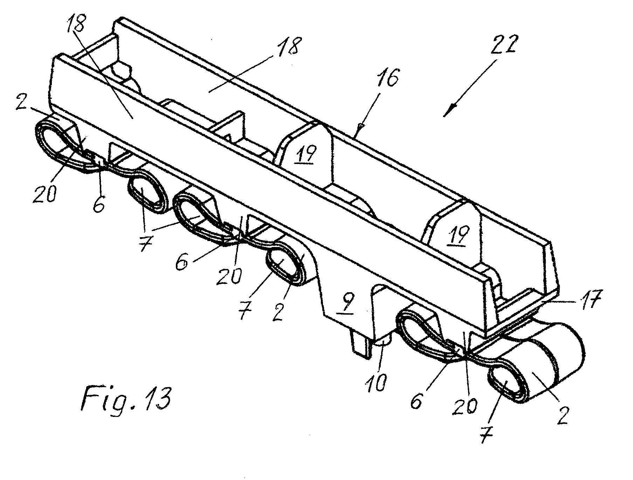

Fig. 13 zeigt eine Fortbildung der Halteklammer nach Fig. 7 bis Fig. 12 als Sechsfach-Halteklammer 22. Gleiche Teile sind mit denselben Bezugszahlen bezeichnet. Im Vergleich zur Vierfach-Halteklammer 15 ist dabei der Klammerträger 16 vom Sockel 9 aus gesehen nach einer Seite verlängert und weist an dieser Verlängerung einen weiteren von seinem Boden 17 abragenden Fortsatz 20 auf, an dem eine oben beschriebene, dritte Niederhaltefeder 2 befestigt ist. Mit dieser Ausführungsform 22 der Erfindung lassen sich somit insgesamt sechs Halbleiter-Bauelemente 13 auch unterschiedlicher Größe und Dicke auf einer Trägerfläche 11 montieren. Auch diese Sechsfach-Halteklammer 22 kann mit Hilfe nur einer durch den Sockel 9 hindurchgehenden Befestigungsschraube 10 auf der Trägerfläche befestigt werden, wonach die Halbleiter-Bauelemente 13 unter den Ösen 7 der Niederhaltefedern 2 platziert werden können und mit hohem Anpressdruck auf die Trägerfläche gepresst werden.

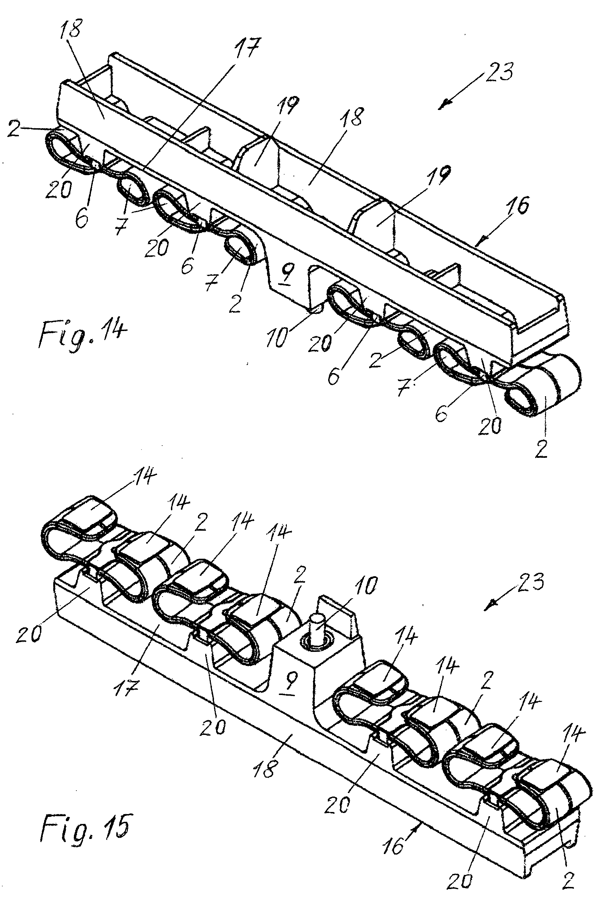

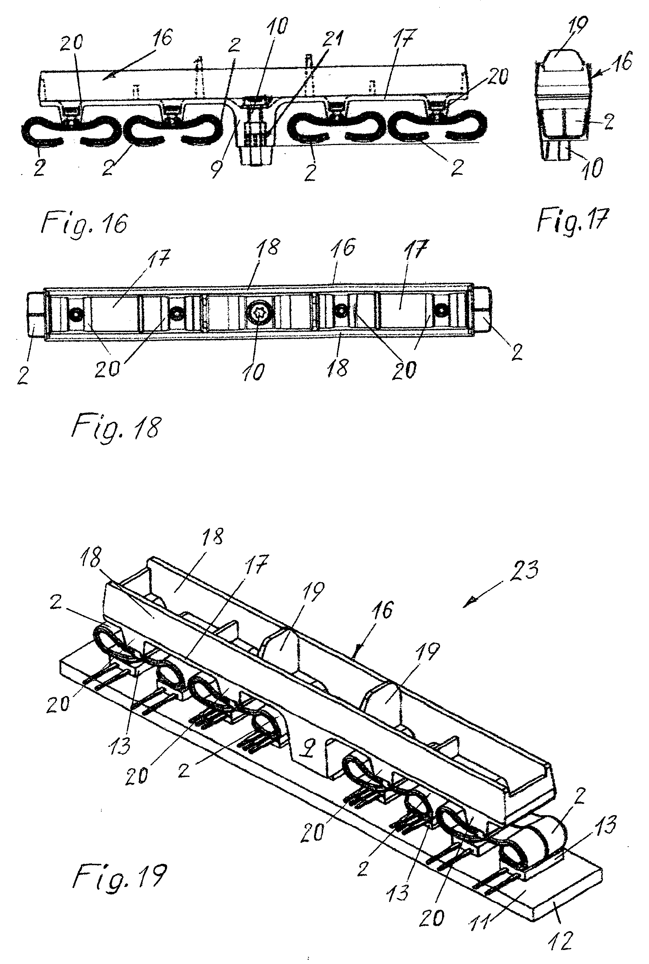

Fig. 14 bis Fig. 19 zeigen eine weitere Fortbildung der Halteklammer nach Fig. 7 bis Fig. 12, und zwar als Achtfach-Halteklammer 23. Gleiche Teile sind mit denselben Bezugszahlen bezeichnet. Im Vergleich zur Vierfach-Halteklammer 15 ist dabei der Klammerträger 16 vom Sockel 9 aus gesehen nach beiden Seiten spiegelbildlich verlängert. An den so entstehenden beiden Armen des Klammerträgers 16 sind beabstandet und spiegelbildlich jeweils zwei, also insgesamt vier, vom seinem Boden 17 abragende Fortsätze 20 ausgebildet. An jedem dieser Fortsätze 20 ist eine Niederhalteklammer 2, wie sie oben beschrieben wurde, durch Schraub- und/oder Schnappverbindung befestigt (siehe auch Fig. 16). Wie in Fig. 19 dargestellt, lassen sich mit dieser Ausführungsform 23 der erfindungsgemäßen Halteklammer insgesamt acht Halbleiter-Bauelemente 13, 13' auch unterschiedlicher Größe und/oder Dicke auf der Trägerfläche 11 eines Unterbaus 12 montieren. Auch der mit der erfindungsgemäßen Halteklammer 23 erreichbare Anspressdruck reicht aus, um die Halbleiter-Bauelemente 13,13' sicher auf der Trägerfläche 11 zu halten. Zur Befestigung auch der Achtfach-Halteklammer 23 auf der Trägerfläche 11 wird nur eine durch den Sockel 9 hindurchgehende Befestigungsschraube 10 benötigt (siehe Fig. 16).

Alle die oben beschriebenen Mehrfach-Halteklammern zeichnen sich durch eine einfache und sehr zeitsparende Montierbarkeit aus, indem sie ausnahmslos mit nur einer Befestigungsschraube 10 auf der Trägerfläche 11 eines Unterbaus 12, auf der die Halbleiter-Bauelemente 13, 13' platziert werden sollen, befestigt werden können. Die erfindungsgemäße Niederhaltefeder 2 gewährleistet durch ihre Form und auch durch das gewählte Material eine sicheren Anspressdruck von 7kp auf die Halbleiter-Bauelemente 13, 13' auch unterschiedlicher Größe und Dicke. Eine hohe Federspannung und ein geringer Federweg werden erreicht. Ihr Kunststoffüberzug macht die Niederhaltefeder 2 spannungsfest auch für den Einsatz von Halbleiter-Bauelementen höherer Leistungsklasse.

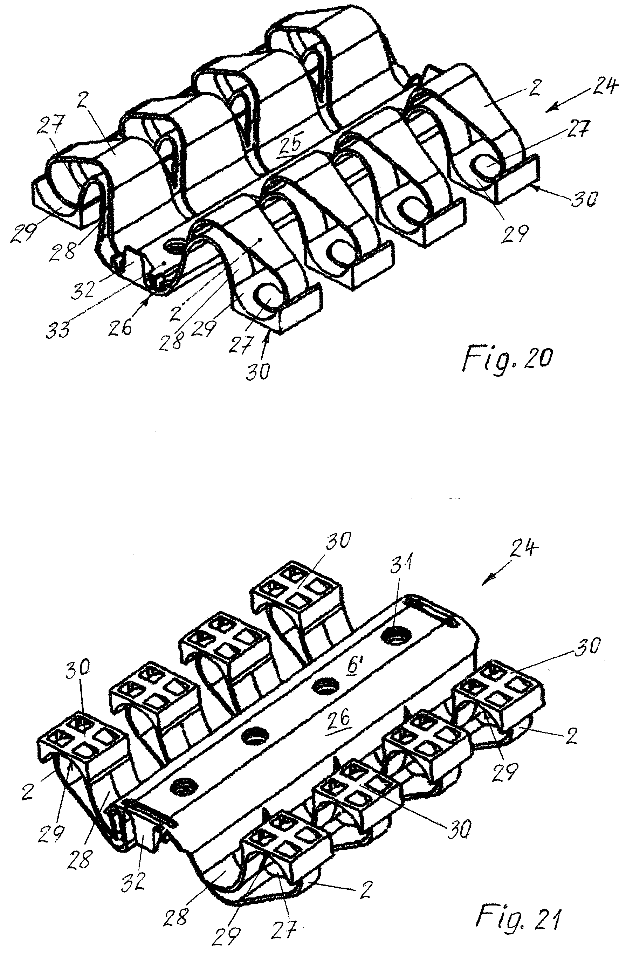

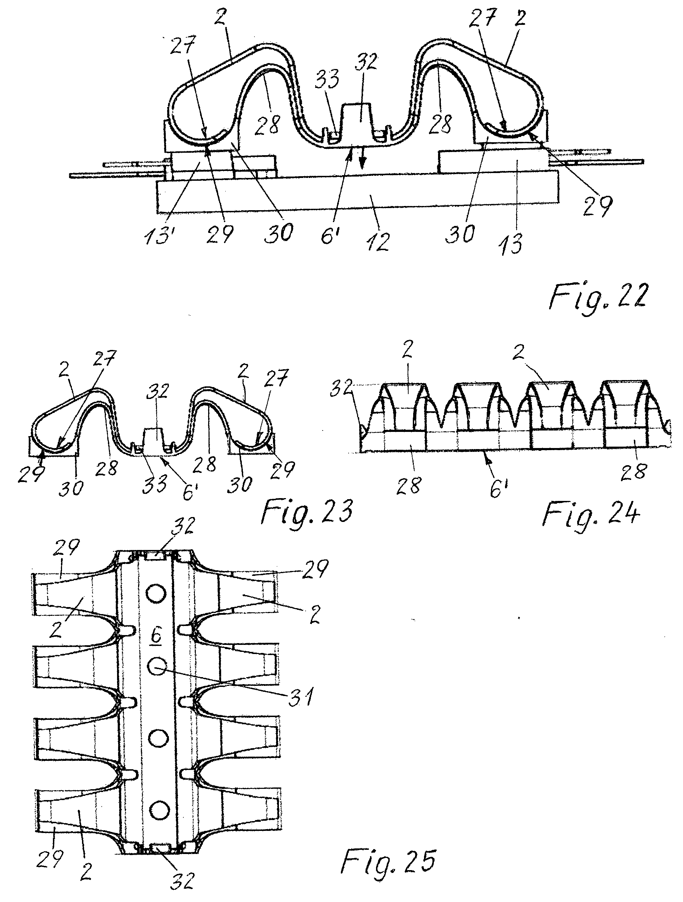

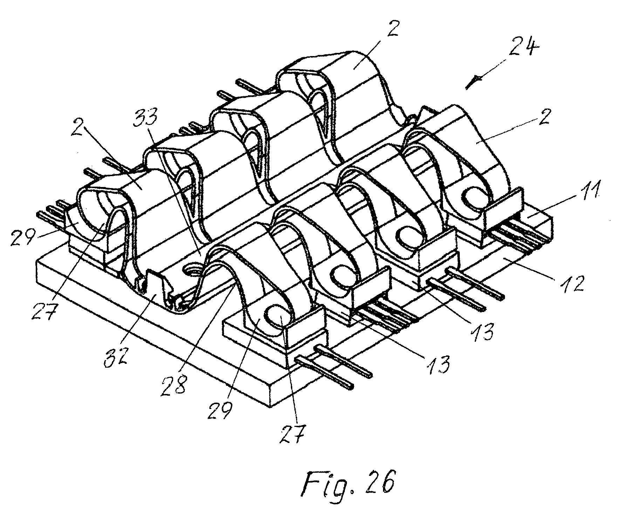

Fig. 20 bis Fig. 26 zeigen eine andere vorteilhafte Ausführungsform 24 der Erfindung am Beispiel einer Achtfach-Halteklammer. Nach dieser Ausführungsform besteht die Halteklammer 24 mit den zugehörigen Niederhaltefedern 2 aus zwei Teilen, einem oberen Teil 25 und einem unteren Teil 26. Am oberen Teil 25 (siehe Fig. 20) erstrecken sich ausgehend wiederum von einem Mittelsteg 6 spiegelbildlich nach beiden Seiten eine Reihe von - im dargestellten Beispiel jeweils vier - Niederhaltefedern 2 aus Federstahl, deren freies Ende auch in dieser Ausführungsform vom Mittelsteg 6 ausgehend zuerst nach oben und dann nach unten und einwärts zu einer Rundung 27 oder Öse gebogen ist. Das untere Teil 26 (siehe auch Fig. 21) weist ebenfalls einen Mittelsteg 6' auf, von dem sich spiegelbildlich nach beiden Seiten eine Reihe von Blattfedern 28 aus Kunststoff erstrecken, deren freies Ende zuerst nach oben, dann nach unten und dann aufwärts zu einer Mulde 29 gebogen ist. Die Unterseite dieser Mulden 29 ist zu einer Aufstandsfläche 30 geformt (siehe Fig. 21). Das obere Teil 25 und das untere Teil 26 der Halteklammer 24 entsprechen sich nach Größe und Maße derart, dass, wenn das obere Teil 25 in das untere Teil 26 eingesetzt wird, die Mittelstege 6, 6' der beiden Teile 25, 26 zur Deckung kommen und die Niederhaltefedern 2 des oberen Teils 25 mit ihrer Rundung 27 zur Auflage kommen in den Mulden 29 der Kunststoff-Blattfedern 28 des unteren Teils 26. Die Mittelstege 6, 6' beider Teile 25, 26 weisen eine Reihe von Schraublöchern 31 auf, die dabei ebenfalls zur Deckung kommen. Die beiden Teile 25, 26, können durch eine Schnappverbindung 32 an den Schalseiten der Mittelstege 6, 6' zusammengehalten werden. Wenn das obere Teil 25 in das untere Teil 26 der Halteklammer 24, wie beschrieben, eingesetzt ist, kann die Halteklammer 24 durch Verschrauben an den Schraublöchern 31 der Mittelstege 6, 6' auf der Trägerfläche 11 eines Unterbaus 12, z. B. eines Kühlkörpers befestigt werden. Die Halteklammer 24 kommt dabei mit den Aufstandsflächen 30 der Kunststoff-Blattfedern 28 zur Auflage auf den zu montierenden Halbleiter-Bauelementen 13 (siehe Fig. 26). Die Mittelstege 6, 6' können gemeinsam durch eine Metallschiene 33 abgedeckt sein, die ebenfalls die entsprechenden Schraublöcher 31 aufweist. Nach dem Festziehen der Schraubverbindungen an den Schraublöchern 31 üben die Niederhaltefedern 2 über die Mulden 29 der Kunststoff-Blattfedern 28 den geforderten Anpressdruck auf die Halbleiter-Bauelemente 13 aus. Indem das untere Teil 26 der Halteklammer 24 einschließlich seiner Blattfedern 28 aus einem geeigneten Kunststoff besteht, wird die notwendige elektrische Isolierung gewährleistet.

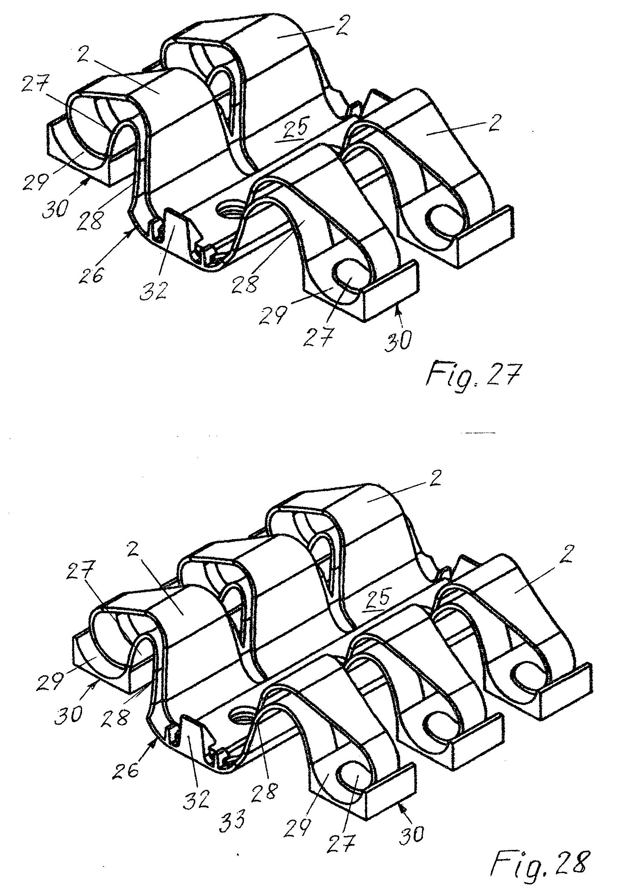

Fig. 27 und Fig. 28 zeigen Ausführungsformen der Halteklammer 24 als Vierfach-Halteklammer (Fig. 27) und als Sechsfach-Halteklammer (Fig. 28). Somit wird deutlich, wie sich die Ausführungsform der Halteklammer 24 an unterschiedliche Vorgaben in einfacher Weise anpassen lässt.

### Bezugszeichenliste

- 1: Halteklammer
- 2: Niederhaltefeder
- 3: Blattfeder (Federstahl)
- 4: Kunststoffschicht
- 5: Enden
- 6: 6' Mittelsteg
- 7: Öse, Rundung
- 8: Kappe
- 9: Sockel
- 10: Befestigungsschraube
- 11: Trägerfläche
- 12: Unterbau
- 13: Halbleiter-Bauelement
- 14: Kunststoffpad
- 15: Vierfach-Halteklammer
- 16: Klammerträger
- 17: Boden
- 18: Seitenwände
- 19: Stützwände
- 20: Fortsätze
- 21: Kunststoffhülse
- 22: Sechsfach-Halteklammer
- 23: Achtfach-Halteklammer
- 24: Achtfach-Halteklammer, 2. Ausführungsform
- 25: Oberes Teil
- 26: Unteres Teil
- 27: Rundung, Öse
- 28: Blattfeder (Kunststoff)
- 29: Mulde
- 30: Aufstandsfläche
- 31: Schraublöcher
- 32: Schnappverschluss
- 33: Metallschiene

## Patentansprüche

1. Halteklammer für die Montage quaderförmiger Klein-Bauteile auf einer ebenen Trägerfläche mit mindestens einer gebogenen Niederhalte-Blattfeder, deren eines Ende mit der Trägerfläche verbindbar ist und deren anderes Ende zur federnden Auflage auf einem auf der Trägerfläche platzierten, quaderförmigen Klein-Bauteil bringbar ist, **dadurch gekennzeichnet, dass** die Niederhaltefeder (2) der Halteklammer (1) aus einer Blattfeder (3) aus Federstahl besteht, deren beide Enden (5) ausgehend von einem Mittelsteg (6) spiegelbildlich zuerst nach oben, dann nach unten und dann einwärts zu einer offenen Öse (6) oder Rundung (27) gebogen sind.

2. Halteklammer nach Anspruch 1, **dadurch gekennzeichnet, dass** die Niederhaltefeder (2) mit einer elektrisch isolierenden Kunststoffschicht (4) überzogen ist.

3. Halteklammer nach Anspruch 1, **dadurch gekennzeichnet, dass** die Niederhaltefeder (2) an ihrer Unterseite mit einem elektrisch isolierenden Sockel (9) verbunden ist, der zwischen den beiden abgebogenen Enden (5) der Niederhaltefeder (2) hindurchragt.

4. Halteklammer nach Anspruch 3, **dadurch gekennzeichnet, dass** eine Befestigungsschraube (10) durch den Mittelsteg (6) und den Sockel (9) hindurchragt und die Halteklammer (1) mit Hilfe dieser Befestigungsschraube (10) mit der Trägerfläche (11) verbindbar ist.

5. Halteklammer nach Anspruch 4, **dadurch gekennzeichnet, dass** der Mittelsteg (6) nach oben von der Fläche der Niederhaltefeder (2) abragt und durch eine metallene Kappe (8) abgedeckt ist, die ebenfalls von der Befestigungsschraube (10) durchstoßen wird.

6. Halteklammer nach Anspruch 2, **dadurch gekennzeichnet, dass** die Unterseite der einwärts zu Ösen (7) gebogenen Enden (5) der Niederhaltefeder (2) zusätzlich zur isolierenden Kunststoffschicht (4) mit einem Kunststoffpad (14) belegt ist.

7. Halteklammer nach Anspruch 2, **dadurch gekennzeichnet, dass** mehr als eine Niederhaltefeder (2) mit einem Klammerträger (16) verbunden sind, von dem ein Sockel (9) abragt, der von einer Befestigungsschraube (10) durchstoßen wird, mit der der Klammerträger (16) samt Niederhaltefedern (2) mit der Trägerfläche (11) verbindbar ist.

8. Halteklammer nach Anspruch 7, **dadurch gekennzeichnet, dass** der Klammerträger (16) einen U-förmigen, aus einem Boden (17) und zwei Seitenwänden (18) gebildeten Körper aufweist, der durch Stützwände (19) innerhalb der U-Form gestützt ist, dass außen von der Mitte des Bodens (17) der Sockel (9) abragt, dass beidseitig des Sockels (9) und im Abstand zum Sockel (9) vom Boden (17) abstehende Fortsätze (20) ausgeformt sind, an denen jeweils eine Niederhaltefeder (2) befestigt ist.

9. Halteklammer nach Anspruch 8, **dadurch gekennzeichnet, dass** jede Niederhaltefeder (2) über ihren nach oben von der Fläche der Niederhaltefeder (2) abragenden Mittelsteg (6) durch Schnappverbindung mit einem der Fortsätze (20) des Klammerträgers (16) verbunden ist.

10. Halteklammer nach Anspruch 8, **dadurch gekennzeichnet, dass** jede Niederhaltefeder (2) über ihren nach oben von der Fläche der Niederhaltefeder (2) abragenden Mittelsteg (6) durch Schraubverbindung mit einem der Fortsätze (20) des Klammerträgers (16) verbunden ist.

11. Halteklammer nach Anspruch 7, **dadurch gekennzeichnet, dass** der Klammerträger (16) aus einem Gussteil besteht und die den Sockel (9) durchstoßende Befestigungsschraube (10) von einer isolierenden Kunststoffhülse (21) eingefasst ist.

12. Halteklammer nach Anspruch 8, **dadurch gekennzeichnet, dass** am Klammerträger (16) beidseitig seines Sockels (9) und zu ihm beabstandet spiegelbildlich jeweils ein Fortsatz (20) ausgebildet ist und dass an den beiden Fortsätzen (20) jeweils eine Niederhaltefeder (2) befestigt ist.

13. Halteklammer nach Anspruch 8, **dadurch gekennzeichnet, dass** am Klammerträger (16) auf einer Seite des Sockels (9) zueinander beabstandet zwei Fortsätze (20) ausgebildet sind und auf der anderen Seite des Sockels (9) ein Fortsatz (20) ausgebildet ist und dass an jedem der Fortsätze (20) eine Niederhaltefeder (2) befestigt ist.

14. Halteklammer nach Anspruch 8, **dadurch gekennzeichnet, dass** am Klammerträger (16) beidseitig seines Sockels (9) und zu ihm beabstandet spiegelbildlich jeweils zwei zueinander beabstandete Fortsätze (20) ausgebildet sind und dass an jedem der Fortsätze (20) eine Niederhaltefeder (2) befestigt ist.

15. Halteklammer nach Anspruch 1, **dadurch gekennzeichnet, dass** die Halteklammer aus zwei Teilen, einem oberen Teil (25) und einem unteren Teil (26), besteht, dass sich am oberen Teil (25) ausgehend von einem Mittelsteg (6) spiegelbildlich nach beiden Seiten eine Reihe von Niederhaltefedern (2) aus Federstahl erstrecken, deren freies Ende ausgehend vom Mittelsteg (6) zuerst nach oben und dann nach unten und dann einwärts zu einer Rundung (27) gebogen ist, dass sich am unteren Teil (26) ausgehend von einem Mittelsteg (6') spiegelbildlich nach beiden Seiten eine Reihe von Blattfedern (28) aus Kunststoff erstrecken, deren freies Ende zuerst nach oben, dann nach unten und aufwärts zu eine Mulde (29) gebogen ist, dass sich das obere Teil (25) und das untere Teil (26) nach Größe und Maße derart entsprechen, dass beim Einsetzen des oberen Teils (25) in das untere Teil (26) die Mittelstege (6, 6') beider Teile (25, 26) zur Deckung kommen und die Niederhaltefedern (2) des oberen Teils (25) mit ihrer Rundung (27) zur Auflage kommen in den Mulden (29) der Kunststoff-Blattfedern (28) des unteren Teils (26).

16. Halteklammer nach Anspruch 15, **dadurch gekennzeichnet, dass** die auf der Trägerfläche zur Auflage kommenden Unterseiten der Mulden (29) der Kunststoff-Blattfedern (28) als Aufstandsflächen (30) ausgebildet sind.

17. Halteklammer nach Anspruch 15, **dadurch gekennzeichnet, dass** die Mittelstege (6, 6') eine Reihe von Schraublöchern (31) aufweisen, die beim Einsetzen des oberen Teils (25) in das untere Teil (26) zur Deckung kommen.

18. Halteklammer nach Anspruch 15, **dadurch gekennzeichnet, dass** das obere Teil (25) und das untere Teil (26) der Halteklammer durch eine Schnappverbindung (32) an den Schmalseiten der Mittelstege (6, 6') miteinander verbunden sind.

19. Halteklammer nach Anspruch 15, **dadurch gekennzeichnet, dass** die zur Deckung gebrachten Mittelstege (6, 6') von einer Metallschiene (33) abgedeckt sind, die Schraublöcher aufweist, die mit den Schraublöchern (31) der Mittelstege (6, 6') zur Deckung kommen.

## Geänderte Patentansprüche

### Geänderte Patentansprüche gemäss Regel 137(2) EPÜ.

1. Halteklammer für die Montage quaderförmiger Klein-Bauteile auf einer ebenen Trägerfläche (11) mit mindestens einer gebogenen Niederhalte-Blattfeder (2) aus Federstahl, die mittig mit der Trägerfläche (11) verbindbar ist und deren beide Enden ausgehend von der mittigen Verbindungsstelle spiegelbildlich zuerst nach oben, dann nach unten und dann einwärts zu einer offenen Öse (7) oder Rundung (27) gebogen sind und auf den auf der Trägerfläche platzierten Klein-Bauteilen zur Auflage bringbar sind, **dadurch gekennzeichnet, dass** an der mittigen Verbindungsstelle der Niederhalte-Blattfeder (2) ein Mittelsteg (6) nach oben abragt und durch eine metallene Kappe (8) abgedeckt ist und dass die Kappe (8), der Mittelsteg (6) und ein in an sich bekannter Weise von der Unterseite der Niederhaltefeder (2) abragender, elektrisch isolierender Sockel (9) von einer Befestigungsschraube (10) zur Verbindung der Halteklammer mit der Trägerfläche (11) durchstoßen wird.

2. Halteklammer nach Anspruch 1, **dadurch gekennzeichnet, dass** die Unterseite der einwärts zu Ösen (7) gebogenen Enden (5) der Niederhaltefeder (2) mit einem Kunststoffpad (14) belegt ist.

3. Halteklammer nach Anspruch 1, **gekennzeichnet durch** einen Klammerträger (16), mit dem mehr als eine Niederhaltefeder *l*2) verbindbar sind und von dem nach unten ein Sockel (9) abragt, der von einer Befestigungsschraube (10) durchstoßen wird, mit der der Klammerträger (16) samt Niederhaltefedem (2) mit der Trägerfläche(11) verbindbar ist.

4. Halteklammer nach Anspruch 3, **dadurch gekennzeichnet, dass** der Klammerträger (16) einen U-förmigen, aus einem Boden (17) und zwei Seitenwänden (18) gebildeten Körper aufweist, der durch Stützwände (19 innerhalb der U-Form gestützt ist, dass außen von der Mitte des Bodens (17) der Sockel (9) abragt, dass beidseitig des Sockels (9) und im Abstand zum Sockel (9) vom Boden (17) abstehende Fortsätze (20) ausgeformt sind, an denen jeweils eine Niederhaltefeder (2) befestigt ist.

5. Halteklammer nach Anspruch 4, **dadurch gekennzeichnet, dass** jede Niederhaltefeder (2) über ihren nach oben von der Fläche der Niederhaltefeder (2) abragenden Mittelsteg (6) durch Schnappverbindung mit einem der Fortsätze (20) des Klammerträgers (16) verbunden ist.

6. Halteklammer nach Anspruch 4, **dadurch gekennzeichnet, dass** jede Niederhaltefeder (2) über ihren nach oben von der Fläche der Niederhaltefeder (2) abragenden Mittelsteg (6) durch Schraubverbindung mit einem der Fortsätze (20) des Klammerträgers (16) verbunden ist.

7. Halteklammer nach Anspruch 3, **dadurch gekennzeichnet, dass** der Klammerträger (16) aus einem Gussteil besteht und die den Sockel (9) durchstoßende Befestigungsschraube (10) von einer isolierenden Kunststoffhülse (21) eingefasst ist.

8. Halteklammer nach Anspruch 4, **dadurch gekennzeichnet, dass** am Klammerträger (16) beidseitig seines Sockels (9) und zu ihm beabstandet spiegelbildlich jeweils ein Fortsatz (20) ausgebildet ist und dass an den beiden Fortsätzen (20) jeweils eine Niederhaltefeder (2) befestigt ist.

9. Halteklammer nach Anspruch 4, **dadurch gekennzeichnet, dass** am Klammerträger (16) auf einer Seite des Sockels (9) zueinander beabstandet zwei Fortsätze (20) ausgebildet sind und auf der anderen Seite des Sockels (9) ein Fortsatz (20) ausgebildet ist und dass an jedem der Fortsätze (20) eine Niederhaltefeder (2) befestigt ist.

10. Halteklammer nach Anspruch 4, **dadurch gekennzeichnet, dass** am Klammerträger (16) beidseitig seines Sockels (9) und zu ihm beabstandet spiegelbildlich jeweils zwei zueinander beabstandete Fortsätze (20) ausgebildet sind und dass an jedem der Fortsätze (20) eine Niederhaltefeder (2) befestigt ist.

11. Halteklammer für die Montage quaderförmiger Klein-Bauteile auf einer ebenen Trägerfläche (11) mit mindestens einer gebogenen Niederhalte-Blattfeder (2) aus Federstahl, die mittig mit der Trägerfläche (11) verbindbar ist und deren beide Enden ausgehend von der mittigen Verbindungsstelle spiegelbildlich zuerst nach oben, dann nach unten und dann einwärts zu einer offenen Öse (7) oder Rundung (27) gebogen sind und auf den auf der Trägerfläche platzierten Klein-Bauteilen zur Auflage bringbar sind, **dadurch gekennzeichnet, dass** die Halteklammer aus zwei Teilen, einem oberen Teil (25) und einem unteren Teil (26), besteht, dass sich am oberen Teil (25) ausgehend von einem Mittelsteg (6) spiegelbildlich nach beiden Seiten eine Reihe von Niederhaltefedem (2) aus Federstahl erstrecken, deren freies Ende ausgehend vom Mittelsteg (6) zuerst nach oben und dann nach unten und dann einwärts zu einer Rundung (27) gebogen ist, dass sich am unteren Teil (26) ausgehend von einem Mittelsteg (6') spiegelbildlich nach beiden Seiten eine Reihe von Blattfedern (28) aus Kunststoff erstrecken, deren freies Ende zuerst nach oben, dann nach unten und aufwärts zu eine Mulde (29) gebogen ist, dass sich das obere Teil (25) und das untere Teil (26) nach Größe und Maße derart entsprechen, dass beim Einsetzen des oberen Teils (25) in das untere Teil (26) die Mittelstege (6, 6') beider Teile (25, 26) zur Deckung kommen und die Niederhaltefedern (2) des oberen Teils (25) mit ihrer Rundung (27) zur Auflage kommen in den Mulden (29) der Kunststoff-Blattfedern (28) des unteren Teils (26).

12. Halteklammer nach Anspruch 11, **dadurch gekennzeichnet, dass** die auf der Trägerfläche zur Auflage kommenden Unterseiten der Mulden (29) der Kunststoff-Blattfedern (28) als Aufstandsflächen (30) ausgebildet sind.

13. Halteklammer nach Anspruch 11, **dadurch gekennzeichnet, dass** die Mittelstege (6, 6') eine Reihe von Schraublöchern (31) aufweisen, die beim Einsetzen des oberen Teils (25) in das untere Teil (26) zur Deckung kommen.

14. Halteklammer nach Anspruch 11, **dadurch gekennzeichnet, dass** das obere Teil (25) und das untere Teil (26) der Halteklammer durch eine Schnappverbindung (32) an den Schmalseiten der Mittelstege (6, 6') miteinander verbunden sind.

15. Halteklammer nach Anspruch 11, **dadurch gekennzeichnet, dass** die zur Deckung gebrachten Mittelstege (6, 6') von einer Metallschiene (33) abgedeckt sind, die Schraublöcher aufweist, die mit den Schraublöchern (31) der Mittelstege (6, 6') zur Deckung kommen.
